# EUROPEAN PATENT APPLICATION

(11) **EP 4 618 142 A1**
(43) Date of publication of application: **17.09.2025**
(21) Application number: 25157189.9
(22) Date of filing: 11.02.2025
(51) Int. Cl.: H01L 23/13, H01L 23/15, H01L 23/498, H05K 1/02, H05K 3/46

(54) **COMPONENT CARRIER WITH INORGANIC LAYER STRUCTURE HAVING CAVITY AND REINFORCING LAYER STRUCTURE**

(30) Priority: 11.03.2024 CN 202410274970
(71) Applicant: AT & S Austria Technologie & Systemtechnik Aktiengesellschaft, 8700 Leoben-Hinterberg (AT)
(72) Inventor: PARK, Ho Sik, Chongqing, 401120 (CN); LUO, Rowling, Chongqing, 40133 (CN); WANG, Tony, Chongqing, 400060 (CN)
(74) Representative: Donatello, Daniele

(57) **Abstract**

A component carrier (100) which comprises a stack (102) comprising at least one electrically conductive layer structure (104) and at least one inorganic layer structure (106), wherein the at least one inorganic layer structure (106) has a planar first main surface (108) and an opposing planar second main surface (110), a geometrically discontinuous region (112) at the first main surface (108), and a reinforcing layer structure (114) at the second main surface (110), wherein the reinforcing layer structure (114) at least partially laterally overlaps with the geometrically discontinuous region (112).

## Description

### Field of the Invention

The invention relates to a component carrier, and to a method of manufacturing a component carrier.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming component carriers are still challenging.

### Summary of the Invention

There may be a need to form a compact and reliable component carrier.

According to an exemplary embodiment of the invention, a component carrier is provided which comprises a stack comprising at least one electrically conductive layer structure and at least one inorganic layer structure, wherein the at least one inorganic layer structure has a planar first main surface and an opposing planar second main surface, a geometrically discontinuous region at the first main surface, and a reinforcing layer structure at the second main surface, wherein the reinforcing layer structure at least partially laterally overlaps with the geometrically discontinuous region.

According to another exemplary embodiment of the invention, a method of manufacturing a component carrier is provided, wherein the method comprises providing a stack comprising at least one electrically conductive layer structure and at least one inorganic layer structure, wherein the at least one inorganic layer structure has a planar first main surface and an opposing planar second main surface, forming a geometrically discontinuous region at the first main surface, and forming a reinforcing layer structure at the second main surface, wherein the reinforcing layer structure at least partially laterally overlaps with the geometrically discontinuous region.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. In particular, a component carrier may be one of a printed circuit board, an organic or inorganic interposer, and an IC (integrated circuit) substrate. For example, a component carrier may be a rigid-flex carrier, or a flexible substrate. A component carrier may also be a hybrid board combining different ones of the above mentioned and/or other types of component carriers.

In the context of the present application, the term "stack" may particularly denote a flat or planar body. For instance, the stack may be a layer stack, in particular an at least partially laminated layer stack. Such a stack may be formed by connecting a plurality of layer structures, which preferably may be arranged in a parallel manner, for example by the application of mechanical pressure and/or heat. The stack may comprise at least one electrically conductive layer structure and at least one electrically insulating structure. A stack may comprise a plurality of sub-stacks, for example may comprise a first multilayer build-up beneath and a further multilayer build-up above an inorganic layer structure.

In the context of the present application, the term "layer structure" may particularly denote a continuous layer, a patterned layer or a plurality of nonconsecutive islands within a common plane. A layer structure may perform the function of providing electrical conductivity and/or electrical insulation.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass or quartz, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS₂, CuGaOz, AgAlO₂, LiGaTe₂, AgInSe₂, CuFeS₂, BeO.

In the context of the present application, the term "geometrically discontinuous region" may particularly denote any structural discontinuity at a planar main surface locally deviating from said planarity. For example, the geometrically discontinuous region may comprise an indentation (such as a cavity, a blind hole, a through hole, etc.) and/or a protrusion (such as a post, a step, a ring, an undulation structure, etc.) surrounded by a planar area of said main surface. For example, the geometrically discontinuous region may be any local non-planarity with respect to a planar surrounding area.

In the context of the present application, the term "reinforcing layer structure" may particularly denote a layer structure (in particular in accordance with the above definition) at a main surface of an inorganic layer structure, which may provide the inorganic layer structure having a geometrically discontinuous region on an opposing other main surface, with a reinforcement function. For example, the reinforcing layer structure may provide the inorganic layer structure with additional crack resistance in comparison with a scenario in which the reinforcing layer structure is absent. More specifically, the reinforcing layer structure may be configured so that the combination of the inorganic layer structure with the reinforcing layer structure is less prone to cracks than the inorganic layer structure without reinforcing layer structure. In particular, said reinforcing layer structure may be configured for at least partially compensating stress created by the geometrically discontinuous region on the opposing main surface, for example during manufacturing the component carrier and/or during use in operation. Said reinforcing layer structure may be configured to at least partially distribute stress from the geometrically discontinuous region on the opposing main surface or the whole opposing main surface evenly to each area or corner of the reinforcing layer structure, therefore the overall stress at one area or point may be reduced significantly and this may mitigate the risk of cracks. For instance during pressure-supported assembly of a component in a cavity constituting the geometrically discontinuous region, stress may be applied to the opposing main surface of the inorganic layer structure, which stress may be reduced by the reinforcing layer structure. For example during lamination of at least one additional layer build-up on one or both opposing main surfaces of the inorganic layer structure, stress may be applied to the inorganic layer structure in view of the geometrically discontinuous region deviating from planarity. The reinforcing layer structure may be configured for at least partially compensating, absorbing and/or reducing and/or distributing stress resulting from the presence of the geometrically discontinuous region.

In the context of the present application, the term "reinforcing layer structure at least partially laterally overlapping with the geometrically discontinuous region" may particularly denote that, in a plan view of the stack in a viewing direction perpendicular to the planar main surfaces of the inorganic layer structure, the reinforcing layer structure and the geometrically discontinuous region may share at least a partial common area. For instance, there may be an overlap between reinforcing layer structure and geometrically discontinuous region in the sense that, in the plan view, a part of the reinforcing layer structure corresponds to a part of the geometrically discontinuous region, a part of the reinforcing layer structure is outside of the geometrically discontinuous region, and a part of the geometrically discontinuous region is outside of the reinforcing layer structure. Alternatively, in the plan view, the geometrically discontinuous region may lie completely inside of the reinforcing layer structure, and the reinforcing layer structure may comprise a portion outside of the geometrically discontinuous region. Further alternatively, in the plan view, the reinforcing layer structure may lie completely inside the geometrically discontinuous region, and the geometrically discontinuous region may comprise a portion outside of the reinforcing layer structure. In still another embodiment, in the plan view, the geometrically discontinuous region and the reinforcing layer structure may be in full alignment or flush with each other. The overlapping may be along the thickness or vertical direction.

In the context of the present application, the term "main surface" of a body may particularly denote one of two largest opposing surfaces of the body or outermost opposing surfaces of the body. The main surfaces may be connected by circumferential side walls. The thickness of a body, such as the inorganic layer structure, may be defined by the distance between the two opposing main surfaces.

According to an exemplary embodiment of the invention, a component carrier (such as a printed circuit board or an integrated circuit substrate) has a (preferably laminated) layer stack having also one or more inorganic layer structures (such as a glass plate). An inorganic layer structure may be more brittle, stiffer and/or less elastic than an organic layer structure. Said at least one inorganic layer structure may have two opposing generally planar main surfaces. However, one of said main surfaces may be provided with a geometrically discontinuous region (such as a cavity) deviating from planarity. Advantageously, the opposing main surface of the at least one inorganic layer structure may be equipped with a reinforcing layer structure in a spatial range of a horizontal plane which overlaps or corresponds to a spatial range of a horizontal plane of the geometrically discontinuous region. Due to the presence of the reinforcing layer structure in spatial relationship with the geometrically discontinuous region, damage of the inorganic layer structure during manufacturing (for instance during a panel level fabrication process) and/or during operation of the component carrier may be reliably prevented, since the reinforcing layer structure may be designed for reducing, inhibiting and/or buffering stress acting on the at least one inorganic layer structure in view of its geometrically discontinuous region. For example, the risk of glass damage during die bonding in a cavity-type geometrically discontinuous region, during which pressure is applied to the at least one inorganic layer structure, may be strongly suppressed by the reinforcing layer structure. Further advantageously, the configuration of the reinforcing layer structure as layer-type reinforcing structure may lead to a low or even no extra space consumption. Consequently, an exemplary embodiment may provide a compact and reliable component carrier.

### Detailed Description of Exemplary Embodiments

In the following, further exemplary embodiments of the component carrier and the method will be explained.

In an embodiment, the geometrically discontinuous region comprises a cavity extending from the first main surface into the at least one inorganic layer structure. Such a cavity may particularly denote an accommodation hole, an opening, a recess or a via in the inorganic layer structure. Such a cavity may be a through hole extending through the entire inorganic layer structure, may be a blind hole extending into the inorganic layer structure but having a closed bottom, or may be a groove or recess of any shape.

In an embodiment, the component carrier comprises at least one component, for example a bridge die, accommodated at least partially in the cavity. In the context of the present application, the term "component accommodated at least partially in the cavity" may particularly denote a component being fully accommodated or only partially accommodated in the cavity in the inorganic layer structure. In a fully accommodated embodiment, the entire vertical spatial range between upper end and lower end of the component is located inside of the cavity. In a partially accommodated embodiment, only part of a vertical spatial range between upper end and lower end of the component is located inside of the cavity, for instance the component may protrude upwardly and/or downwardly beyond the cavity. In one embodiment, the upper end of the at least partially accommodated component may be in alignment with an upper main surface of the inorganic layer structure and/or the lower end of the component may be in alignment with a lower main surface of the inorganic layer structure. For instance, the component may be an electrical component for providing an electrical function (such as a semiconductor chip), a thermal component for providing a cooling function (such as a copper or ceramic block) and/or an optical component providing an optical function. Said optical component may for instance be an optical chip, an optoelectronic device, or an optical connector. When the component is configured as a bridge die, it may be electrically coupled with a second component and with a third component for establishing an electric connection between said second component and said third component. Said second and third components may be surface mounted on and/or embedded in the inorganic layer structure.

In an embodiment, an external electrically conductive layer structure of the at least one electrically conductive layer structure is arranged on the first main surface and is arranged at another vertical level than an electrically conductive pad (such as a chip terminal) at an upper main surface of the component. Such a vertical misalignment between component pad and an external electrically conductive layer structure on the inorganic layer structure may be the result of an embedding process.

In an embodiment, the geometrically discontinuous region comprises a protrusion extending upwardly from the first main surface beyond the at least one inorganic layer structure. Also a protrusion at a top side of an inorganic layer structure may lead to stress on a bottom side thereof, for instance by applying stress during lamination. A reinforcing layer structure on the bottom side of the inorganic layer structure may help to prevent damage of the inorganic layer structure in view of the stress caused by the top-sided protrusion.

In an embodiment, the reinforcing layer structure is arranged on the second main surface. For example, the reinforcing layer structure may be formed as a patterned layer, for example a patterned copper foil, being applied onto the second main surface of the inorganic layer structure. This may bring the advantage of compensating and/or redistributing applied stress or pressure in an efficient way, while at the same time inhibiting crack-formation inside the inorganic layer structure. Meanwhile, the inorganic layer structure may be equipped with an electrical element to transfer electricity.

In an embodiment, the reinforcing layer structure is electrically conductive, for example forms part of the at least one electrically conductive layer structure. This may bring the advantage that substantially no extra effort is required for manufacturing the reinforcing layer structure, since it can be formed simultaneously with an electrically conductive layer structure provided in the stack anyway. For example, a portion of a common patterned metal layer may be configured as reinforcing layer structure, whereas another portion of said common patterned metal layer may be configured for providing an electrical function.

In an embodiment, at least a portion of the electrically conductive layer structure is formed apart from the reinforcing layer structure. For instance, the other part of the electrically conductive layer structure which is provided in addition to the reinforcing layer structure may be a peripheral part, whereas the reinforcing layer structure may be a central part of a common electrically conductive layer structure. This may bring the advantage of subdividing the electrically conductive layer structure so that it can be configured for transmitting current and/or signals. The electrically conductive layer structures may also be configured for ensuring physical and/or mechanical integrity of the stack of the component carrier.

In an embodiment, the reinforcing layer structure forms traces and/or pads, for example is a pattern which forms traces and/or pads. In such an embodiment, the reinforcing layer structure may fulfill a double function, i.e. may contribute to the electric functionality of the component carrier by forming traces and/or pads and may simultaneously function for reinforcing the inorganic layer structure's bottom side against stress.

In an embodiment, the reinforcing layer structure is formed as a continuous structure, for example as a continuous layer. Such a continuous structure may extend over the entire spatial area of the geometrically discontinuous region on the opposing other main surface of the inorganic layer structure. For instance, the reinforcing layer structure may be a continuous metal layer, such as a copper foil or a plating structure. This may allow the reinforcing layer structure to provide its reinforcing function over a continuous spatial range.

In an embodiment, the reinforcing layer structure extends laterally over the entire geometrically discontinuous region, for example is aligned laterally with the entire geometrically discontinuous region. This may provide a particularly reliable protection of the inorganic layer structure against damage. It may however also be that the reinforcing layer structure (partially or completely) laterally extends inside the geometrically discontinuous region.

In an embodiment, the reinforcing layer structure extends laterally over at least part of a boundary profile of the geometrically discontinuous region. This may bring the advantage of efficiently guiding and/or distributing applied stress or pressure over the portion of the stack spatially exceeding the profile of the geometrically discontinuous region resulting in a reliable crack inhibition of the inorganic layer structure. For example, said boundary profile may be formed by an edge and/or a corner portion of the geometrically discontinuous region.

In an embodiment, the reinforcing layer structure can extend over the whole opposing main surface facing away from the geometrically discontinuous region. A pattern extending beyond the area of the geometrically discontinuous region can be used to perform the function of the reinforcing layer structure or supporting structure, for example except an electrical function. With such kind of structure, the stress can be distributed to more points or areas, each single area may just have to withstand less pressure, and the entire area may withstand a higher pressure. Meanwhile, the pattern of the whole surface can be any pattern contributing to fulfill the function required in accordance with a design.

In an embodiment, the reinforcing layer structure is inorganic and/or electrically insulating, for example forms part of the at least one inorganic layer structure. For example, a bottom portion of the inorganic layer structure can be constructed, structured or patterned so as to form a bottom-sided profile corresponding spatially at least partially with the geometrically discontinuous region for self-protecting the inorganic layer structure against stress. The profile may be of such kind that particularly the portions on the lower main surface of the inorganic layer structure being prone to damage in the event of stress applied to the opposing geometrically discontinuous region are locally reinforced.

In an embodiment, the reinforcing layer structure is configured and connected with the stack for dissipating heat. For instance, the reinforcing layer structure may be made of a highly thermally conductive material, such as copper, aluminum or a ceramic, having a thermal conductivity of at least 50 W/mK. In particular when thermally coupled with electrically conductive layer structures of the stack, which may be made of copper and may thus have an excellent thermal conductivity as well, the reinforcing layer structure may form part of a heat removal path for removing heat generated in the component carrier during operation. For instance, a main heat source of such a component carrier may be an embedded electronic component, which may be thermally coupled with the reinforcing layer structure for heat dissipation.

In an embodiment, the reinforcing layer structure is electrically coupled with the at least one electrically conductive layer structure, for example for transmitting electric signals and/or electric power. Thus, the reinforcing layer structure itself may contribute to the electronic functionality of the component carrier.

In another embodiment, the reinforcing layer structure is functionally inactive apart from its reinforcing function. In particular, the reinforcing layer structure of such an embodiment may be decoupled electrically with respect to the electrically conductive layer structures of the stack. In terms of the actual functionality of the component carrier, the reinforcing layer structure of such an embodiment may be a dummy structure used only for reinforcing the inorganic layer structure during a manufacturing process.

In an embodiment, the reinforcing layer structure is electrically decoupled from the at least one electrically conductive layer structure. For instance, the reinforcing layer structure may be embodied as one or more metallic islands being separate from the other electrically conductive layer structures.

In an embodiment, the at least one inorganic layer structure forms a core of the stack. Hence, the inorganic layer structure may form a vertically central support body forming a base for additional organic layer structures on one or both opposing main surfaces thereof. Such a core structure may provide mechanical stability, may contribute to the electrical wiring of the component carrier (in particular for signal transport and/or supply of electric energy), and/or may contribute to heat removal.

In an embodiment, the at least one inorganic layer structure comprises or consists of at least one of glass, ceramic, semiconductor, for example silicon, and silica. Thus, appropriate materials for an inorganic layer structure are glass (in particular silicon-based glass), a ceramic (such as aluminum nitride and/or aluminum oxide), and a material comprising a semiconductor (such as silicon oxide, silicon, silicon carbide, gallium nitride, etc.). It is also possible to make the inorganic layer structure of a metallic material, such as copper. This may bring the advantage of having a big pool of material having individual chemical and/or physical properties and thus enable a freedom of material choice during design and/or manufacture of the stack.

In an embodiment, the reinforcing layer structure has a force sustainability of at least 40 Newton. With such a configuration, the reinforcing layer structure may be capable of withstanding forces as occur typically during a die attach process during which an electronic component is pressed into a cavity in the inorganic layer structure for attaching it.

In an embodiment, at least 50%, for example 60% to 80%, of a surface area of the second main surface overlapping with the surface area of the geometrically discontinuous region at the first main surface is covered by material of the reinforcing layer structure. This may ensure a sufficiently large reinforcing effect being achievable by the reinforcing layer structure.

In an embodiment, a first percentage of a coverage with material of the reinforcing layer structure in a first surface area of the second main surface overlapping with a surface area of the geometrically discontinuous region at the first main surface deviates (or differs) from a second percentage of a coverage with material of the at least one electrically conductive layer structure in a second surface area of the second main surface apart from the first surface area by not more than 20%, for example by not more than 10%. On the one hand, a certain deviation between first percentage and second percentage may allow to adjust the reinforcing function and the electric current conducting function of the component carrier individually. On the other hand, an excessive deviation between the first and second percentages may lead to a strongly asymmetric construction of the component carrier, which may increase warpage. When limiting the deviation to not more than 20% and preferably not more than 10%, a freedom of design and a low warpage configuration may be combined.

In an embodiment, a thickness of the at least one inorganic layer structure is not more than 500 µm, for example not more than 200 µm. In view of the continuing trend of miniaturization, a thin inorganic layer structure may be desired. However, very thin inorganic layer structures may render the latter prone to failure in the event of mechanical stress. By the provision of a reinforcing layer structure as described herein, stress exerted to the inorganic layer structure may be reduced, redirected, absorbed and/or suppressed so that the mentioned thin inorganic layer structures become possible without the risk of failure.

In an embodiment, the component carrier comprises at least one layer build-up which comprises organic material and which is formed on the first main surface and/or on the second main surface. For example, such a multilayer build-up may comprise an electrical wiring structure, a redistribution structure and/or heat dissipating structures. One multilayer build-up may be formed on or above the inorganic layer structure by lamination, i.e. the application of heat and/or pressure. This may bring the advantage of forming complex electrically conductive layer structures in combination in an easy and well established manner. However, said stack may also comprise one multilayer build-up on or above one main surface of the inorganic layer structure and/or the geometrically discontinuous region and another multilayer build-up on or above another main surface of the inorganic layer structure and/or the reinforcing structure. In one embodiment, the multilayer build-ups may be asymmetric with respect to each other. Although conventionally asymmetric multilayer build-ups on two opposing main surfaces of a core or another central carrier structure may be a root cause of warpage and delamination, the provision of a stiff and mechanically robust inorganic layer structure (preferably made of glass) in combination with a reinforcing layer structure also allows such an asymmetric build-up. This increases the freedom of design of the component carrier designer. Alternatively, the multilayer build-ups may be symmetric with respect to each other.

In an embodiment, a multilayer build-up on one main surface of the inorganic layer structure has a higher integration density of electrically conductive structures than another multilayer build-up on an opposing other main surface of the inorganic layer structure. The term "integration density" may denote a number of electrically conductive structures per area or volume of the respective region of the component carrier. In particular, the amount of contacts (including pads) per area or volume of one multilayer build-up may be higher than the amount of the contacts (including pads) per area or volume on the other multilayer build-up. Thus, integration density may mean a quantity of electrically conductive structures (such as traces) per mm². The integration density above and below the inorganic layer structure can be different. For instance, integration density may be higher at a multilayer build-up facing a surface mounted device (such as a semiconductor chip). Thus, the multilayer build-up of the component carrier having the higher integration density may provide a mounting area for mounting one or a plurality of electronic components such as semiconductor chips. Preferably, the multilayer build-up of the component carrier having the higher integration density may be formed on the first main surface of the inorganic layer structure.

In an embodiment, the at least one electrically conductive layer structure comprises at least one vertical through connection extending over an entire thickness of the at least one inorganic layer structure. Advantageously, one or more vertical through connections such as copper pillars and/or copper filled laser vias extending through the entire thickness of the inorganic layer structure may electrically couple multilayer build-ups on two opposing main surfaces of the inorganic layer structure. Thus, even complex electrically conductive paths may be formed.

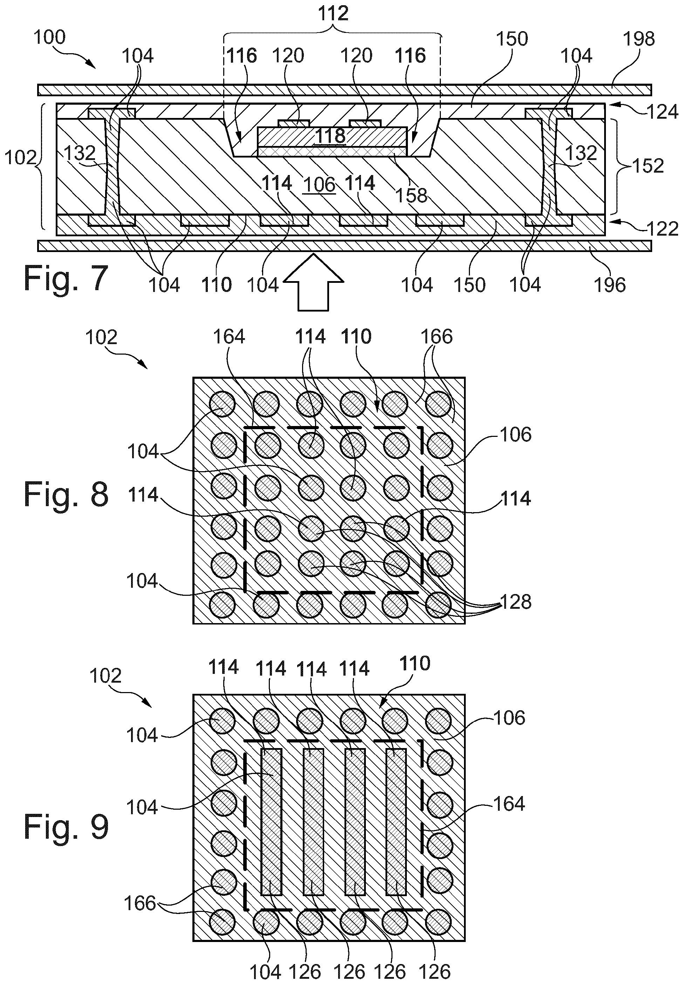

In an embodiment, the reinforcing layer structure comprises a matrix-like arrangement of reinforcing pads (see Figure 8). Additionally or alternatively, the reinforcing layer structure comprises an array of reinforcing stripes arranged side-by-side (see Figure 9). With such configurations, a simple manufacturing process and an effective reinforcement may be combined.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates a cross-sectional view, and a plan view, of a component carrier according to an exemplary embodiment of the invention.
Figure 3 illustrates a stress distribution at a planar surface of a component carrier according to an exemplary embodiment of the invention in comparison with a conventional component carrier, as obtained from simulations.
Figure 4 illustrates a detail of a component carrier according to an exemplary embodiment of the invention.
Figure 5 and Figure 6 illustrate diagrams indicating results of a simulation of stress acting on a component carrier according to an exemplary embodiment of the invention in comparison with a conventional component carrier.
Figure 7 illustrates a cross-sectional view of a component carrier according to an exemplary embodiment of the invention.
Figure 8 illustrates a plan view of a component carrier according to an exemplary embodiment of the invention.
Figure 9 illustrates a plan view of a component carrier according to an exemplary embodiment of the invention.
Figure 10 illustrates a cross-sectional view of a component carrier according to another exemplary embodiment of the invention.
Figure 11 to Figure 13 illustrate bottom main surfaces of a stack of a component carrier with a reinforcing layer structure according to different exemplary embodiments of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Glass core substrates are considered as a replacement for organic substrates. In conventional approaches of manufacturing component carriers based on a glass plate with cavity in which an electronic component (such as a die) is to be embedded, there may be issues concerning glass damage during die bonding. More specifically, a glass core may be prone to breakage during a die bonding and pressure stage.

According to an exemplary embodiment of the invention, a component carrier (for instance a PCB) may be provided with a (for example laminated) layer stack having also one or more inorganic layer structures (which may be made of glass). Optionally, it may also be possible to have a further layer build-up including organic layer structures (such as prepreg or resin layers) on one or both opposing main surfaces of the inorganic layer structure. The inclusion of at least one inorganic layer structure may involve a potentially brittle structure tending to crack under the influence of mechanical stress, force or pressure. In particular when one of planar main surfaces of an inorganic layer structure has a geometrically discontinuous region (for instance a recess for embedding a component), mechanical stress, pressure and/or force may be critical for the mechanical integrity of the inorganic layer structure, in particular on its opposing other side. Beneficially, the other main surface of the inorganic layer structure opposing the geometrically discontinuous region may be equipped with a spatially partially or entirely corresponding reinforcing layer structure. Such a reinforcing layer structure may suppress mechanical stress caused by the geometrically discontinuous region during manufacturing the component carrier or during ordinary use. This may for instance reduce the danger of crack formation at the inorganic layer structure, for instance caused by pressing a component to be embedded into a cavity, as geometrically discontinuous region, of the inorganic layer structure. Forming the reinforcing layer structure as thin layer structure may strictly limit space consumption of the component carrier in vertical direction. As a result, a compact and reliable component carrier may be provided by an exemplary embodiment. In particular, exemplary embodiments of the invention may reduce the crack risk in a glass core cavity area, and may reduce high stress deformation by the provision of a reinforcing layer structure.

A gist of an exemplary embodiment of the invention is a specific design for an inorganic layer stack with geometrically discontinuous region, in particular a glass core with cavity for embedding an electronic component therein. According to this design, a reinforcing layer structure in form of a copper pad may be formed on the back side of the glass core in a cavity area to release stress exerted to the glass core during embedding the component. Thus, the provision of a reinforcing layer structure may lead to a mechanical stress depression. Advantageously, this may lower the risk of glass crack. Furthermore, this may have a positive impact on warpage control of the component carrier. Thus, exemplary embodiments may bring the advantage of reducing process stress during manufacture to protect the glass, which may lower the risk of glass crack. Beneficially, simulations of the die bonding process indicate the presence of less stress thanks to the provision of the reinforcing layer structure on the back side of the inorganic layer structure. After die bonding, there may be an encapsulation process for forming a layer build-up on the front side and/or on the back side of the at least one inorganic layer structure. For example, lamination of resin sheets or prepreg sheets may occur when forming a layer build-up. Lamination pressure may be exerted to the constituents of the component carrier in this context, and beneficially the reinforcing layer structure (for instance embodied as one or more simple copper pads) may release the stress and may thereby protect the at least one inorganic layer structure against breakage, crack or damage. In particular in view of larger and larger cavity sizes and/or numbers, larger and larger sizes and/or numbers of components to be embedded, thinner and thinner inorganic layer structure (such as one or more glass cores), the provision of a reinforcing layer structure (such as one or more properly designed and positioned copper pads) on the cavity area may make a panel or component carrier stronger and may lower the risk of crack formation during the manufacturing process. Simultaneously, a corresponding component carrier or panel may show improved warpage properties thanks to the provision of the reinforcing layer structure. Thus, the reinforcing layer structure may also balance warpage, especially in the presence of an asymmetric build-up or structure. Advantageously, a reinforcing layer structure embodied as one or more copper pads may render the copper density on the back side of the at least one inorganic layer structure of the panel or the component carrier more evenly or more balanced. This may lower the undulation risk of one or more laminated organic layer structures due to the volume of the dielectric layer for encapsulation in the cavity. The lamination on the two surfaces can be reduced, which may allow to better control the flatness of the dielectric layer(s).

When forming a component carrier with inorganic layer structure, for instance in glass core technology, there may be a higher risk of glass crack issues compared with a purely organic substrate. Exemplary embodiments of the invention provide a design with a reinforcing layer structure on a main surface of an inorganic layer structure facing laterally a geometrically discontinuous region on the other main surface. This may lower the risk of glass crack issues, and may contribute to a higher yield of a manufacturing process.

To put it shortly, an exemplary embodiments may apply a crack prevention portion, in form of the reinforcing layer structure, to a glass substrate with cavity and accommodated component. Thus, a crack of a glass substrate can be avoided. For example, the use of back side pads, as an example for the reinforcing layer structure, on the glass substrate may reliably avoid a crack of glass due to mechanical impact. In other words, one or more pads may be provided on the back side of an inorganic layer structure facing a geometrically discontinuous region, such as a cavity, on the front side for mechanical stress dissipation. Advantageously, a reinforcing layer structure embodied as one or more metal pads in a back side main surface region corresponding at least partially with an opposing geometrically discontinuous region in a front side main surface region can be manufactured simultaneously with other metal pads at the same height level but located peripherally. In other words, the reinforcing pads and the peripheral other pads may be manufactured in a common process, for instance by patterning a common metal layer. Thus, substantially no extra effort may be involved in the manufacture of the reinforcing layer structure.

According to an exemplary embodiment of the invention, a component carrier is provided which comprises a stack comprising at least one electrically conductive layer structure and at least one inorganic layer structure, said at least one inorganic layer structure comprising a first planar main surface and an opposed second planar main surface, wherein the first main surface comprises a disrupted portion (which may also be denoted as geometrically discontinuous region) having a different extension from the main planar surface extension, and on the second main surface comprises a reinforcing layer structure at least partially overlapping the disrupted portion from the top view.

The following advantageous embodiments are possible: In an embodiment, the disrupted portion comprises a cavity. At least one component may be provided or embedded in the cavity, in particular a bridge die (such as a die having features such as exposed pads suitable to be connected to at least two components for connecting said at least two components). For example, an external electrically conductive layer structure on the first main surface and the component and/or the conductive area of the component are at a different vertical position. For instance, the disrupted portion comprises a protrusion extending beyond the first planar main surface. In an embodiment, the reinforcing layer structure is provided on the second main surface. For example, the reinforcing layer structure comprises a metallic layer structure, in particular corresponding to at least one portion of the at least one electrically conductive layer structure of the stack. In an embodiment, the at least one electrically conductive layer structure comprises a further portion of structures beside the reinforcing layer structure. In other words, the reinforcing portion and the further portion may flush one to each other along the stack thickness direction. For instance, the reinforcing layer structure comprises traces and/or pads. For example, the reinforcing layer structure is in the form of a pattern of pads and/or traces. In an embodiment, the reinforcing layer comprises a continuous structure. In this context, "continuous" may mean not comprising patterned structures, for instance a foil shape. For example, the reinforcing layer structure has a planar extension within the planar extension of the disrupted portion. For instance, the reinforcing layer structure has a planar extension at least partially overlapping the boundary profile of the planar extension of the disrupted portion. In an embodiment, the reinforcing layer structure comprises at least a portion overlapping with one edge and/or corner portion of the disrupted portion. For example, the reinforcing layer structure comprises an inorganic layer structure (for instance comprising glass, a ceramic, etc.). In an embodiment, the reinforcing layer structure is configured and connected with the stack to dissipate heat and/or to be electrically connected to the at least one electrically conductive layer structure (for instance to transmit signals and/or for power transmission). For example, the reinforcing layer structure is insulated from the other electrically conductive layer structures. For instance, the at least one inorganic layer structure is a core for the stack. In an embodiment, the at least one inorganic layer structure comprises at least one of glass, ceramic, silicon, and quartz. For instance, the force sustainability of the at least one inorganic layer structure and/or of the reinforcing layer structure is at least 40 N, for example is not more than 80 N. In an embodiment, the pressure distribution of the metallic structure depends on the design of the metallic structure

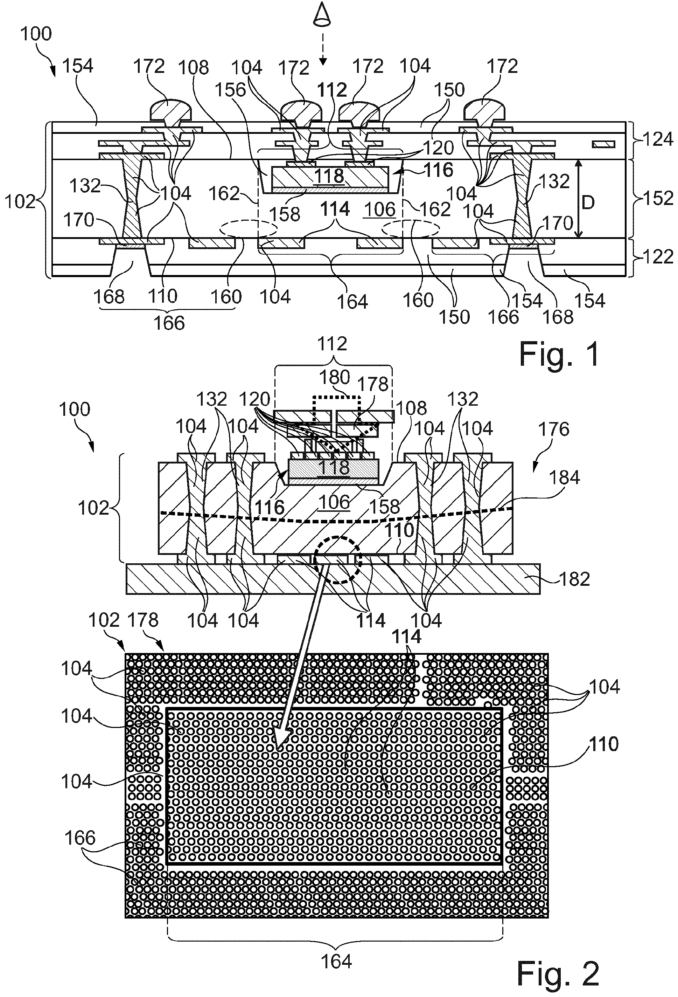

**Figure 1** illustrates a cross-sectional view of a component carrier 100 according to an exemplary embodiment of the invention. For instance, the component carrier 100 according to Figure 1 may be embodied as an integrated circuit (IC) substrate or as a printed circuit board (PCB) with an inorganic core.

The illustrated component carrier 100 comprises a stack 102 having a plurality of electrically insulating layer structures 106, 150 and a plurality of electrically conductive layer structures 104. The electrically insulating layer structures 106, 150 may comprise at least one inorganic layer structure 106 and at least one organic layer structure 150. In the shown embodiment, stack 102 is composed of a lower sub-stack in form of a laminated lower multilayer build-up 122 and of a laminated upper sub-stack in form of an upper multilayer build-up 124. A central sub-stack 152 may be a core between the multilayer build-ups 122, 124. Each of the layer build-ups 122, 124 may comprise organic material, such as an epoxy resin, and may be formed on a respective one of a first main surface 108 and a second main surface 110 of the central sub-stack 152. An adhesion promotor may be located between the central sub-stack 152 and the lower layer build-up 122 arranged on the second main surface 110 and/or an adhesion promotor may be located between the central sub-stack 152 and the upper layer build-up 124 arranged on the first main surface 108.

Additionally, there may be a structure that forms a pattern directly on the glass surface (for instance formed by sputtering a metal film on the glass as seed layer). However, there might be a risk of delamination between the glass surface and seed layer, so an adhesion promotor may be added between the seed layer and the glass surface. The adhesion promotor can be a metal layer such as a titanium layer which can improve the adhesion between the glass and the seed layer. Or it may be possible to treat the glass surface by a chemical or gas to change the property of the glass surface to improve the adhesion between the glass and the seed layer or the resin.

The electrically conductive layer structures 104 may comprise patterned copper layers which may form horizontal pads and/or a horizontal wiring structure. Additionally or alternatively, the electrically conductive layer structures 104 may comprise vertical through connections such as copper pillars and/or copper filled laser vias. Moreover, the organic electrically insulating layer structures 150 may be for example prepreg or resin sheets. The outermost organic electrically insulating layer structures 150 may form a solder mask 154. The central inorganic layer structure 106 is here embodied as a glass core or glass plate, but may also be made of a ceramic, a semiconductor, quartz, etc. For example, a thickness D of the inorganic layer structure 106 may be not more than 500 µm, for example 400 µm. Such very thin glass cores may be highly preferred for manufacturing compact component carriers 100, but may be prone to damage by mechanical load. Alternatively, the thickness D of the inorganic layer structure 106 may be in a range from 500 µm to 1000 µm. The lower multilayer build-up 122 is formed below the inorganic layer structure 106 and the upper multilayer build-up 124 is formed above the inorganic layer structure 106.

As shown, the inorganic layer structure 106 has planar first main surface 108 and opposing planar second main surface 110. However, a geometrically discontinuous region 112 is formed in the first main surface 108. The geometrically discontinuous region 112 is formed as a cavity 116 extending from the first main surface 108 into the inorganic layer structure 106. For example, cavity 116 may be formed as a blind hole in the inorganic layer structure 106. For instance, cavity 116 may be formed by laser processing, mechanical abrasion and/or etching. The cavity 116 may have a round shape, for example a cylindrical shape, or an edged shape, for example a squared shape. As shown, an electronic component 118 may be accommodated in the cavity 116 for embedding it in stack 102. For instance, the electronic component 118 may be a semiconductor die, for example a bridge die. It is also possible that electronic component 118 is substituted by multiple electronic components in cavity 116, or that a component with another functionality than an electronic functionality is inserted in cavity 116. For example, a copper block or a ceramic block may be inserted as component in cavity 116 for heat removal purposes. Gaps or unfilled regions of the cavity 116 between the component 118 and the inorganic layer structure 106 may be filled by a filling material 156. Filling material 156 may for instance be a resin material or a glue. For example, gaps or unfilled regions may be filled by laminating the organic layer structure 150 of layer build-up 124 on top of the inorganic layer structure 106 after embedding the component 118. A resin flow from organic layer structure 150 into cavity 116 during lamination may then constitute the filling material 156.

When inserting component 118 in cavity 116 formed in the planar main surface 108 of inorganic layer structure 106, a tape 158 (such as a die bonding type) on a bottom main surface of the electronic component 118 may be pressed with pronounced force onto the bottom of the cavity 116 for fixing the component 118 in the cavity 116. In view of the brittle and inelastic properties of glass or the like used for forming the inorganic layer structure 106, crack issues may occur under the cavity 116 in conventional approaches, in particular in crack-critical regions shown schematically with reference sign 160 in Figure 1.

According to a preferred embodiment of the invention, the risk of damage of the inorganic layer structure 106 during the manufacturing process (in particular during applying force or pressure for component embedding) may be reduced by providing a reinforcing layer structure 114 at the second main surface 110 of the inorganic layer structure 106. For instance, the reinforcing layer structure 114 has a force sustainability of at least 40 Newton. As shown, the reinforcing layer structure 114 largely overlaps in a lateral direction with the geometrically discontinuous region 112 in form of cavity 116. More precisely, in a viewing direction 174 perpendicular to parallel planar main surfaces 108, 110, the geometrically discontinuous region 112 deviating from planarity, on the one hand, and the reinforcing layer structure 114, on the other hand, may be partially or even entirely in alignment with each other in a lateral direction, as indicated by alignment lines 162. In Figure 1, the reinforcing layer structure 114 extends laterally over the extension of the geometrically discontinuous region 112 and is aligned at its exterior lateral ends with the exterior lateral ends of the geometrically discontinuous region 112. Preferably, a laterally exterior outline of the geometrically discontinuous region 112 at the first main surface 108 may correspond to a laterally exterior outline of the reinforcing layer structure 114 on the second main surface 110 of the inorganic layer structure 106. In an embodiment, an absolute value of a difference between an area delimited by an exterior outline of the reinforcing layer structure 114 and an area delimited by an exterior outline of the geometrically discontinuous region 112, divided by the area delimited by the exterior outline of the geometrically discontinuous region 112 may be not more than 20%, preferably not more than 10%. Preferably, the reinforcing layer structure 114 may extend laterally over a boundary profile of the geometrically discontinuous region 112, wherein said boundary profile may be formed by an edge and/or a corner portion of the geometrically discontinuous region 112. Generally, the entire surface area or only part of the surface area of the second main surface 110 overlapping with the surface area of the geometrically discontinuous region 112 on the first main surface 108 may be covered by reinforcing material, such as copper in the example of Figure 1. In the embodiment of Figure 1, about 60% to 70% of the surface area of the second main surface 110 overlapping with the surface area of the geometrically discontinuous region 112 at the first main surface 108 is covered by material of the reinforcing layer structure 114.

In the shown embodiment, the reinforcing layer structure 114 is constituted by an array of electrically conductive structures, such as copper pads, arranged on the second main surface 110 below the geometrically discontinuous region 112 at the first main surface 108. Additionally or alternatively, the reinforcing layer structure 114 may comprise one or more electrically insulating elements, for example may form part of a correspondingly adapted second main surface 110 of the inorganic layer structure 106 (not shown).

Advantageously, the reinforcing layer structure 114 may form part of the electrically conductive layer structure 104 at the bottom side of the inorganic layer structure 106, i.e. on the second main surface 110. More specifically, the reinforcing layer structure 114 may be formed by a central part 164 of a patterned metal layer of said electrically conductive layer structure 104. In addition, a peripheral portion 166 of said electrically conductive layer structure 104, laterally surrounding said central part 164, is formed apart from the reinforcing layer structure 114 and forms traces and/or pads of the component carrier 100. Elements of said electrically conductive layer structure 104 of the peripheral portion 166 may thus be electrically connected with further electrically conductive layer structures 104 of component carrier 100. For instance, elements of said electrically conductive layer structure 104 of the peripheral portion 166 may be electrically coupled by vertical through connections 132 extending through the inorganic layer structure 106 up to electrically conductive layer structures 104 of the opposing layer build-up 124. As shown, the vertical through connections 132 extend over the entire thickness D of the inorganic layer structure 106 and electrically interconnect the layer build-ups 122, 124 with each other. Thus, elements of said electrically conductive layer structure of the peripheral portion 166 may have an electronic functionality.

In contrast to this, elements of said electrically conductive layer structure 104 of the central portion 164 constituting the reinforcing layer structure 114 may be non-functional apart from their reinforcing function. In particular, said elements of said electrically conductive layer structure 104 of the central portion 164 constituting the reinforcing structure 114 may have no electronic function during operation of the component carrier 100. In such an embodiment, the reinforcing layer structure 114 may be functionally inactive apart from its reinforcing function and may be electrically decoupled from the other electrically conductive layer structures 104. On the structure of the central portion 164 and/or the peripheral portion 166, an adhesion promotor may be applied. This may reduce the risk of delamination.

In another embodiment, it may however be possible that the reinforcing layer structure 114 of the central portion 164 is a pattern which forms traces and/or pads having an electronic functionality during operation of the component carrier 100, for instance being electrically coupled with other electrically conductive layer structures 104 of the stack 102. The density or amount of members of the reinforcing structure 114 in the central portion 164 may be different compared to the peripheral portion 166. Alternatively, density or amount of members may be the same in the central portion 164 as in the peripheral portion 166. Thus, the reinforcing layer structure 114 may also be electrically coupled with at least one of the electrically conductive layer structures 104 for transmitting electric signals and/or electric power during operation of the component carrier 100.

In particular, a first percentage of a coverage with material of the reinforcing layer structure 114 in a first surface area of the second main surface 110 overlapping with a surface area of the geometrically discontinuous region 112 at the first main surface 108 may deviate or differ from a second percentage of a coverage with material of the at least one electrically conductive layer structure 104 in a second surface area of the second main surface 110 apart from the first surface area, for instance by less than 50%, preferably by 10%-20%. For example, the amount of copper used for reinforcing purposes in the central part 164 of the lowermost electrically conductive layer structure 104 may be selected differently from an amount of copper used for electrical connections purposes in the peripheral path 166 of the lowermost electrically conductive layer structure 104. Besides the amount of copper, there may be different designs for the shapes of copper and/or a different size of the pattern. This allows to adjust the copper content locally for optimizing the reinforcing and electric functions. However, the copper density below cavity 116 may be not too different from the copper density apart from the cavity 116 in order to avoid warpage resulting from an asymmetric configuration.

Still referring to multilayer build-up 122, access holes 168 may be formed (for instance by laser drilling or mechanically drilling) through electrically insulating layer structures 150 for exposing elements of the lowermost electrically conductive layer structure 104 belonging to the peripheral portion 166. A surface finish 170 (for instance made of ENIG or ENEPIG) may be applied to exposed surfaces of said electrically conductive layer structure 104. For example, the surface finish 170 may form an electric ground layer.

Now referring to multilayer build-up 124, electrically conductive connection elements 172 may be applied on exposed surfaces of the uppermost electrically conductive layer structure 104, which may also be exposed by forming access holes in the uppermost electrically insulating layer structure 150. For example, said electrically conductive connection elements 172 may be solder bumps. Although not shown in Figure 1, one or more surface mounted components, for instance electronic components such as semiconductor chips, may be assembled on the electrically conductive connection elements 172. Said surface mounted components may be coupled with each other via the embedded electronic component 118 in accordance with its functionality as bridge die. The embedded electronic component 118 may be externally accessible by copper laser vias and copper pads forming electrically conductive layer structures 104 above the electronic component 118. As shown, an external electrically conductive layer structure 104 arranged externally from the inorganic layer structure 106 on the first main surface 108 thereof can be arranged at another vertical level than an electrically conductive pad 120 at an upper main surface of the component 118.

**Figure 2** illustrates a cross-sectional view 176 and a plan view 178 of a component carrier 100 according to an exemplary embodiment of the invention.

The construction of Figure 2 corresponds largely to the construction of Figure 1 but only shows the central sub-stack 152 of Figure 1. Furthermore, Figure 2 shows how pressure is applied by a pressure applicator 178 in a direction 180 during die attach of component 118 in cavity 116. A support plate 182 (for instance made of a metal) on the bottom side of stack 102 holds the stack 102 in place during die attach. During this force application, the bottom side of the glass core may be prone to damage, and warpage 184 may occur in conventional approaches. However, by providing the reinforcing layer structure 114 on the second main surface 110 below the geometrically discontinuous region 112 on the first main surface 108 of the glass core, damage of the glass core may be avoided and warpage 184 may be reduced.

As shown in plan view 178, the reinforcing structure 114 may be a matrix-like array of copper pads in a central part 164 of electrically conductive layer structure 104 on the second main surface 110 of the inorganic layer structure 106.

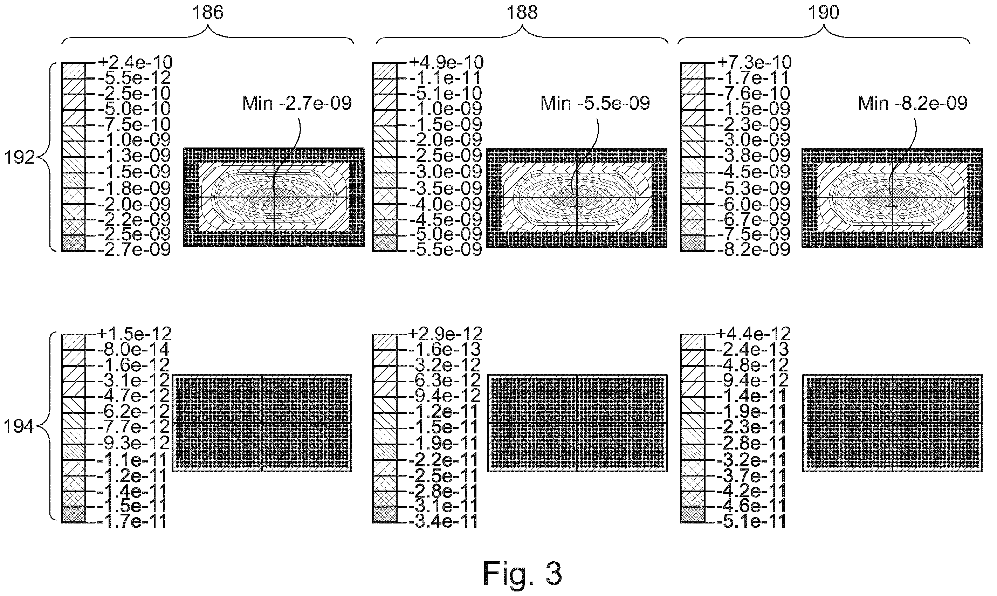

**Figure 3** illustrates a stress distribution at a planar surface of a component carrier 100 according to an exemplary embodiment of the invention in comparison with a conventional component carrier, as obtained from simulations.

More specifically, Figure 3 shows a stress distribution at main surface 110 of inorganic layer structure 106 without reinforcing layer structure 114 (see upper row 192 in Figure 3) and with reinforcing layer structure 114 (see lower row 194 in Figure 3). This comparison is shown for an applied die bonding force of 10 Newton (see left column 186 in Figure 3), 20 Newton (see middle column 188 in Figure 3), and 30 Newton (see right column 190 in Figure 3). As seen, the provision of reinforcing layer structure 114 significantly reduces the stress applied in particular to the central part of main surface 110. More specifically, Figure 3 shows out-of-plane deformation in millimeters after application of pressure in a die-bonding load case. The illustrated glass core stress analysis shows that the risk of failures in the glass core due to the die bonding force may be significantly reduced by the formation of the reinforcing layer structure 114 in regard to the stress/strain characteristics in the glass. According to Figure 3, the impact of the die bonding force is indicated by evaluating the stress in the glass core for the three mentioned bonding forces.

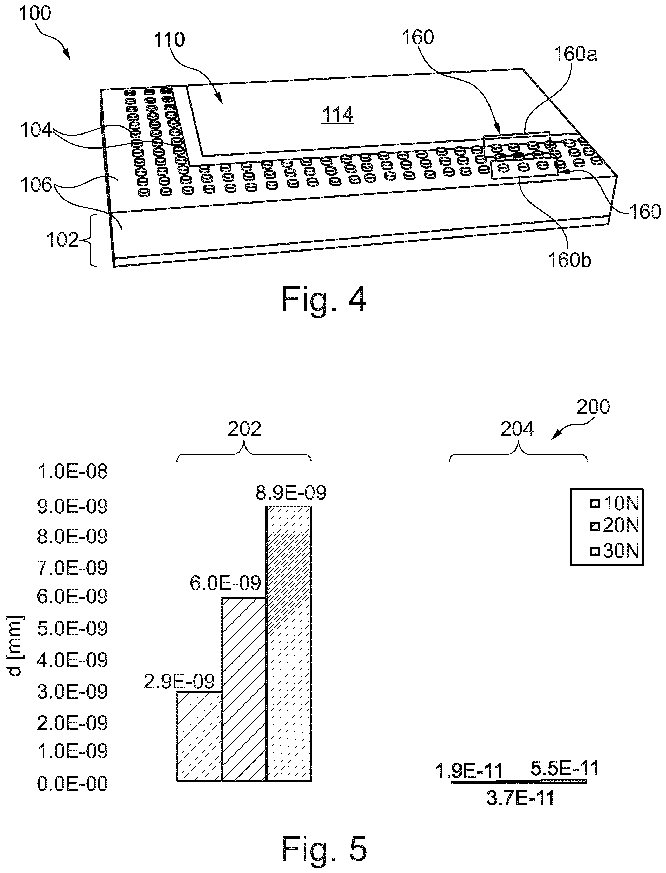

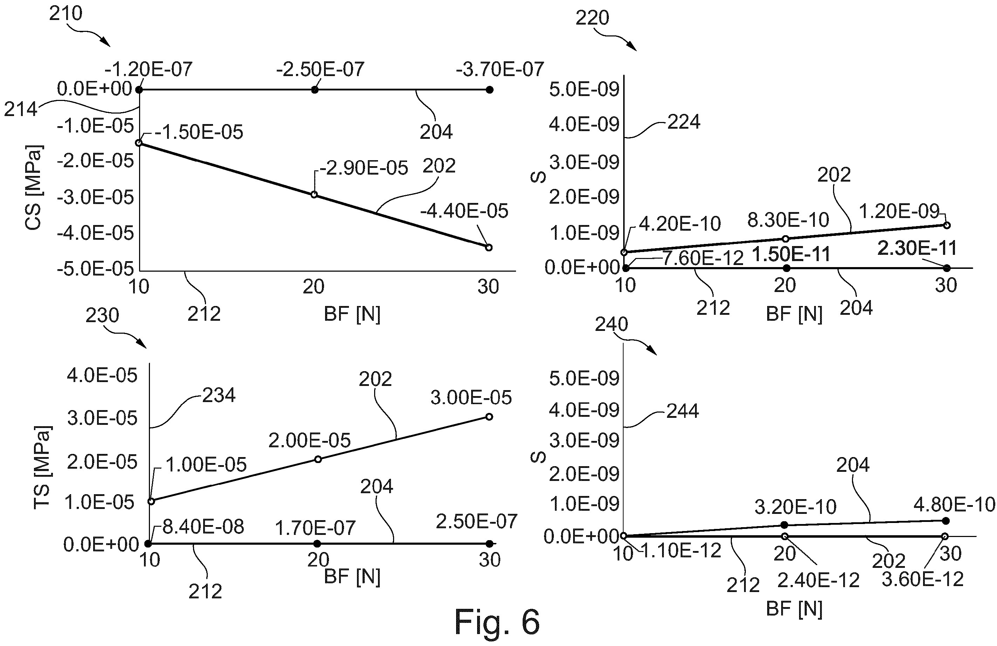

**Figure 4** illustrates a detail of a component carrier 100 according to an exemplary embodiment of the invention. More specifically, Figure 4 shows critical regions 160 of the inorganic layer structure 106 which are specifically prone to damage in the event of mechanical stress and which can be reliably protected against failure by the application of the reinforcing layer structure 114. Said critical regions 160 include a first position 160a and a second position 160b, which will be evaluated in further detail by Figure 6.

**Figure 5** and **Figure 6** illustrate diagrams 200, 210, 220, 230, and 240 indicating results of a simulation of stress acting on a component carrier 100 according to an exemplary embodiment of the invention in comparison with a conventional component carrier. In particular, stress and strain results are shown in the glass-material.

Referring to diagram 200 of Figure 5, three scenarios are shown for the application of a die bonding force of 10 Newton, 20 Newton, and 30 Newton. The results are plotted for a conventional component carrier without reinforcing layer structure (see reference sign 202), and a component carrier 100 according to an exemplary embodiment of the invention with reinforcing layer structure 114 (see reference sign 204). As shown in Figure 5, the absolute deflection d (in mm) may be significantly reduced by the addition of the reinforcing layer structure 114.

Now referring to Figure 6, diagram 210 has an abscissa 212 plotting bonding force BF and has an ordinate 214 plotting compression stress CS for position 160a of Figure 4.

Diagram 220 has an abscissa 212 plotting bonding force BF and has an ordinate 224 plotting strain S for position 160a of Figure 4.

Diagram 230 has an abscissa 212 plotting bonding force BF and has an ordinate 234 plotting tensile stress TS for position 160b of Figure 4.

Diagram 240 has an abscissa 212 plotting bonding force BF and has an ordinate 244 plotting strain S for position 160b of Figure 4.

As shown in diagrams 210, 220, 230, 240 the results are better in a scenario in which reinforcing layer structure 114 is present (see reference sign 204) compared with a scenario in which reinforcing layer structure 114 is absent (see reference sign 202).

**Figure 7** illustrates a cross-sectional view of a component carrier 100 according to an exemplary embodiment of the invention. As shown in Figure 7, laminating additional organic layer structures 150 (such as resin sheets or prepreg sheets) on top and on bottom of the inorganic layer structure 106 by heated press plates 196, 198 may also create mechanical stress. Also in this scenario, the reinforcing layer structure 114 opposing the geometrically discontinuous region 112 may protect the inorganic layer structure 106 against damage and may suppress warpage.

**Figure 8** illustrates a plan view of a component carrier 100 according to an exemplary embodiment of the invention. More specifically, Figure 8 shows a plan view on main surface 110 of inorganic layer structure 106 being provided with a reinforcing layer structure 114. In the illustrated embodiment, the reinforcing layer structure 114 comprises a matrix-like arrangement of reinforcing pads 128 in central part 164, such as copper pads arranged in rows and columns.

**Figure 9** illustrates a plan view of a component carrier 100 according to an exemplary embodiment of the invention.

More specifically, Figure 9 shows a plan view on main surface 110 of inorganic layer structure 106 being provided with a reinforcing layer structure 114. In the illustrated embodiment, the reinforcing layer structure 114 comprises an array of parallel elongate reinforcing stripes 126 arranged side-by-side in central part 164, such as copper strips arranged in parallel.

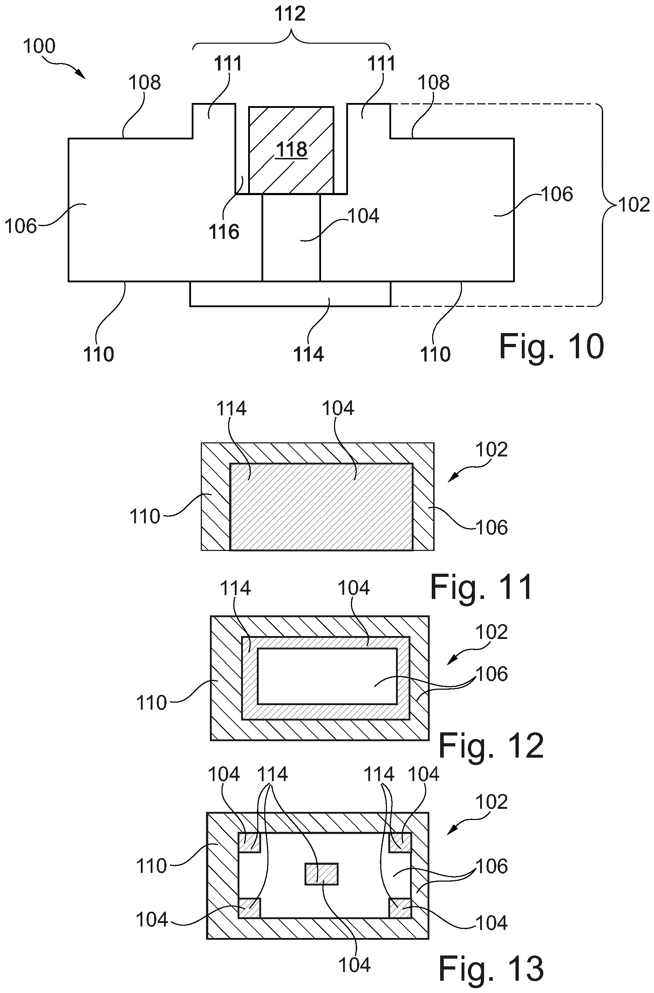

**Figure 10** illustrates a cross-sectional view of a component carrier 100 according to another exemplary embodiment of the invention.

The embodiment of Figure 10 differs from the embodiment of Figure 1 in particular in that, according to Figure 10, the reinforcing layer structure 114 is formed as a continuous layer over the entire extension of an opposing geometrically discontinuous region 112. Moreover, the geometrically discontinuous region 112 of Figure 10 comprises a protrusion 111 extending upwardly from the first main surface 108 beyond the inorganic layer structure 106. The protrusion 111 may be a ring surrounding a cavity 116 in which an electronic component 118 is inserted. In the embodiment of Figure 10, the reinforcing layer structure 114 is thermally coupled with the electronic component 118 by a vertical through connection in form of an electrically conductive layer structure 104, which may be made of copper. Alternatively, a plurality of vertical through connections may connect the backside of the electronic component 118. This may enable the use of chips having a front side and back side connection. Thus, heat created by electronic component 118 during operation of the component carrier 100 may be removed via the vertical through connection and the reinforcing layer structure 114, so that the latter contributes for dissipating heat.

Figure 11 to Figure 13 illustrate bottom main surfaces 110 of a stack 102 of a component carrier 100 with a reinforcing layer structure 114 according to different exemplary embodiments of the invention.

Referring to **Figure 11****,** the reinforcing layer structure 114 comprises only one big pad covering the whole central part area. Hence, a single continuous structure may constitute the reinforcing layer structure 114 in the region opposing the geometrically discontinuous region 112 on the opposing side of the stack 102.

Referring to **Figure 12****,** the reinforcing layer structure 114 comprises an annular metallic structure. It is also possible that the reinforcing layer structure 114 comprises multiple (for example four) square pads surrounding multiple (for example four) edges of the central part. Thus, one or more rings may constitute the reinforcing layer structure 114 in the region opposing the geometrically discontinuous region 112 on the opposing side of the stack 102.

Referring to **Figure 13****,** the reinforcing layer structure 114 comprises multiple (for example four) pads at multiple (for example four) corners of a central part and/or at least one pad at the center of said multiple pads.

Hence, plural central and peripheral pads may constitute the reinforcing layer structure 114 in the region opposing the geometrically discontinuous region 112 on the opposing side of the stack 102.

Generally, the reinforcing layer structure 114 may have a lot of different designs in accordance with a specific application for the sustainability of pressure required (for instance, a design of the reinforcing layer structure 114 can be calculated based on the required pressure sustainability for a certain design).

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) comprising at least one electrically conductive layer structure (104) and at least one inorganic layer structure (106), wherein the at least one inorganic layer structure (106) has a planar first main surface (108) and an opposing planar second main surface (110);
a geometrically discontinuous region (112) at the first main surface (108); and
a reinforcing layer structure (114) at the second main surface (110), wherein the reinforcing layer structure (114) at least partially laterally overlaps with the geometrically discontinuous region (112).

2. The component carrier (100) according to claim 1, wherein the geometrically discontinuous region (112) comprises a cavity (116) extending from the first main surface (108) into the at least one inorganic layer structure (106).

3. The component carrier (100) according to claim 2, comprising at least one component (118), for example a bridge die, accommodated at least partially in the cavity (116).

4. The component carrier (100) according to claim 1, wherein the geometrically discontinuous region (112) comprises a protrusion (111) extending upwardly from the first main surface (108) beyond the at least one inorganic layer structure (106).

5. The component carrier (100) according to any of claims 1 to 4, wherein the reinforcing layer structure (114) is arranged on the second main surface (110).

6. The component carrier (100) according to any of claims 1 to 5, wherein the reinforcing layer structure (114) is electrically conductive, for example forms part of the at least one electrically conductive layer structure (104).

7. The component carrier (100) according to any of claims 1 to 6, wherein the reinforcing layer structure (114) forms traces and/or pads, for example is a pattern which forms traces and/or pads.

8. The component carrier (100) according to any of claims 1 to 7, wherein the reinforcing layer structure (114) is formed as a continuous structure, for example as a continuous layer.

9. The component carrier (100) according to any of claims 1 to 8, wherein the reinforcing layer structure (114) extends laterally over the entire geometrically discontinuous region (112), for example is aligned laterally with the entire geometrically discontinuous region (112); and/or
wherein the reinforcing layer structure (114) extends laterally over at least part of a boundary profile of the geometrically discontinuous region (112), wherein for example said boundary profile is formed by an edge and/or a corner portion of the geometrically discontinuous region (112).

10. The component carrier (100) according to any of claims 1 to 9, comprising at least one of the following features:
wherein the reinforcing layer structure (114) is functionally inactive apart from its reinforcing function;
wherein the reinforcing layer structure (114) is electrically decoupled from the at least one electrically conductive layer structure (104).

11. The component carrier (100) according to any of claims 1 to 10, wherein the at least one inorganic layer structure (106) comprises or consists of at least one of glass, ceramic, semiconductor, for example silicon, and silica.

12. The component carrier (100) according to any of claims 1 to 11, wherein at least 50%, for example 60% to 80%, of a surface area of the second main surface (110) overlapping with the surface area of the geometrically discontinuous region (112) at the first main surface (108) is covered by material of the reinforcing layer structure (114).

13. The component carrier (100) according to any of claims 1 to 12, comprising at least one layer build-up (122, 124) which comprises organic material and which is formed on the first main surface (108) and/or on the second main surface (110).

14. The component carrier (100) according to any of claims 1 to 13, wherein the reinforcing layer structure (114) comprises an array of reinforcing stripes (126) arranged side-by-side.

15. A method of manufacturing a component carrier (100), wherein the method comprises:
providing a stack (102) comprising at least one electrically conductive layer structure (104) and at least one inorganic layer structure (106), wherein the at least one inorganic layer structure (106) has a planar first main surface (108) and an opposing planar second main surface (110);
forming a geometrically discontinuous region (112) at the first main surface (108); and
forming a reinforcing layer structure (114) at the second main surface (110), wherein the reinforcing layer structure (114) at least partially laterally overlaps with the geometrically discontinuous region (112).
